# EUROPEAN PATENT APPLICATION

(11) **EP 4 783 407 A1**
(43) Date of publication of application: **29.07.2026**
(21) Application number: 25795024.6
(22) Date of filing: 21.04.2025
(51) Int. Cl.: H02J 7/00, H01M 10/6563, H01M 10/613, H01M 10/617, H01M 10/6551, H01M 10/6552, H05K 7/20

(54) **CHARGING/DISCHARGING DEVICE FOR SECONDARY BATTERY**

(30) Priority: 24.04.2024 KR 20240054667
(71) Applicant: LG Energy Solution, Ltd., Seoul 07335 (KR)
(72) Inventor: SHIN, Jong Kwang, Daejeon 34122 (KR); KIM, Hong Kyun, Daejeon 34122 (KR); KIM, Min Hong, Daejeon 34122 (KR); SHIN, Un Seop, Daejeon 34122 (KR); MOON, Kyu Jin, Daejeon 34122 (KR); CHOI, Young Sang, Daejeon 34122 (KR); KANG, Byung Kwun, Daejeon 34122 (KR)
(74) Representative: Goddar, Heinz J.
(86) International application number: PCT/KR2025/005363
(87) International publication number: WO 2025/225986

(57) **Abstract**

A secondary battery charging and discharging device related to one example of the present invention comprises a chamber including one or more charging spaces capable of individually accommodating trays, in which secondary batteries are accommodated, and provided with charging grippers arranged to be electrically connectable with the secondary batteries in the charging space, a thermoelectric cooling part including a thermoelectric element, and cooling fins arranged to transfer cold air from a cooling side of the thermoelectric element to surroundings, and arranged to cool air in the charging space at an upper portion of the charging space, a first fan provided to suck cooling air from the surroundings of the thermoelectric cooling part at an upper portion of the charging space and to blow the cooling air toward the secondary batteries accommodated in the tray, and a second fan provided so that the cooling air flows along the longitudinal direction of the secondary battery by sucking air in parallel with the longitudinal direction of the secondary battery at a lower portion of the charging space.

## Description

### Technical Field

The present invention relates to a secondary battery charging and discharging device, and more specifically, relates to a secondary battery charging and discharging device capable of eliminating temperature deviations between multiple secondary batteries being charged and discharged in one tray.

This application claims the benefit of priority based on Korean Patent Application No. 10-2024-0054667 dated April 24, 2024, the disclosure of which is incorporated herein by reference in its entirety.

### Background Art

As demand for mobile devices increases and spread of electric vehicles, and the like expands, demand for secondary batteries as an energy source rapidly increases, and among them, demand for lithium secondary batteries having high capacities and energy densities is high.

In general, the lithium secondary battery is manufactured by placing an electrode assembly composed of a negative electrode, a positive electrode, and a separator in a cylindrical or rectangular metal can or a pouch-shaped case made of an aluminum laminate sheet, and injecting an electrolyte into the electrode assembly.

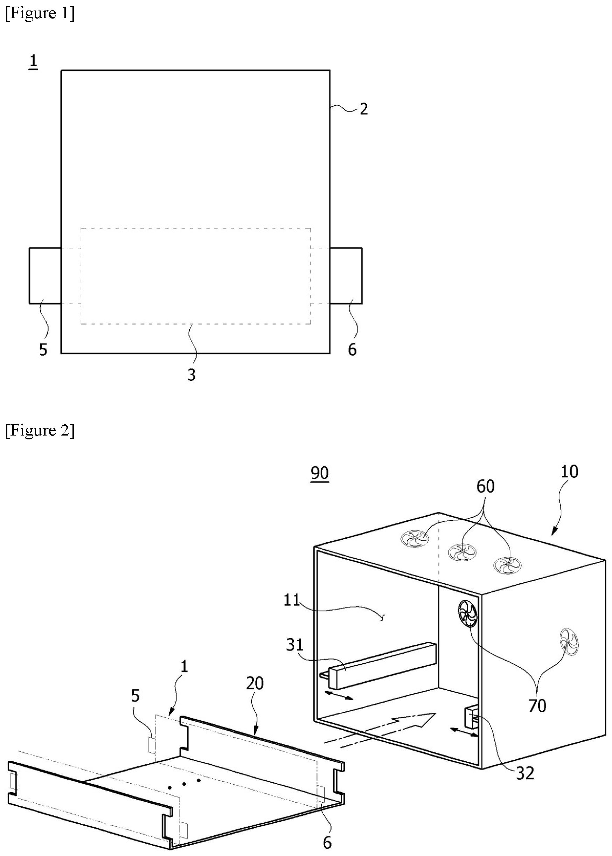

Figure 1 is a diagram for explaining a pouch-shaped secondary battery.

Referring to Figure 1, the pouch-shaped secondary battery (1) comprises a pouch-shaped case (2) having a gas pocket, an electrode assembly (3) accommodated in the pouch-shaped case (2), and a first electrode lead (5) and a second electrode lead (6) connected to the electrode assembly (3) and protruding from both sides of the pouch-shaped case (2). The electrode assembly (3) is obtained by sequentially laminating a negative electrode and a positive electrode via a separator.

The first electrode lead (5) is obtained by connecting the positive electrodes of the electrode assembly (3) into one. The second electrode lead (6) is obtained by connecting the negative electrodes of the electrode assembly (3) into one.

The lithium secondary battery thus manufactured must be subjected to activation of the battery by performing predetermined charging and discharging, whereby it can function as a battery. This process is called a formation process or an activation process.

For such an activation process, a charging and discharging device (90) is used. The charging and discharging device (90) can charge and discharge multiple secondary batteries (1) simultaneously to increase productivity in a mass production process of secondary batteries.

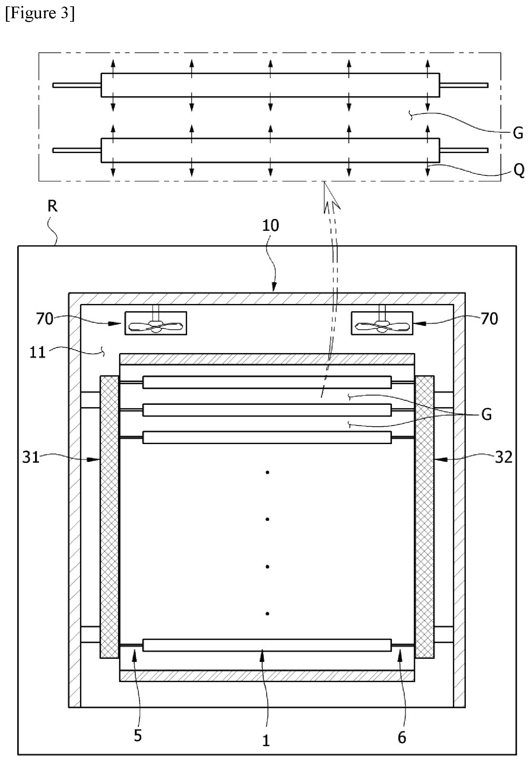

Figures 2 and 3 are diagrams for explaining wind flows upon operation of a blower fan in a conventional secondary battery charging and discharging device. Figure 2 schematically illustrates a perspective diagram of a chamber having a tray in which multiple secondary batteries (1) are accommodated, and a charging space, and Figure 3 schematically illustrates a plan view of a charging space into which a tray is inserted.

Referring to Figure 2, the charging and discharging device (90) is installed in an activation room (R). The activation device comprises a chamber (10) having a plurality of charging spaces (11), a plurality of blower fans (60, 70) installed in each charging space (11), and a pair of charging grippers (31, 32) installed in each charging space (11).

The chamber (10) is arranged so that the charging space (11) is opened to the activation room (R). The chamber (10) is arranged so that one tray (20) can be accommodated in each charging space (11). A plurality of secondary batteries (1) is accommodated in the one tray (20).

The plurality of secondary batteries (1) is charged in the charging space (11) in a state where the batteries are accommodated in the one tray (20). The secondary battery (1) undergoes an electrochemical reaction during charging and discharging, and heat (Q) is generated in this process. The heat is an interfering factor directly affecting the performance of the secondary battery (1).

The heat (Q) generated during charging and discharging of the secondary batteries (1) is dissipated to gap spaces (G) which are surroundings of the secondary batteries (1). The gap space (G) is a space between two adjacent secondary batteries (1). The respective gap spaces (G) are each arranged between two secondary batteries (1) along the arrangement direction of the secondary batteries (1).

Referring to Figure 3, the heat of the secondary battery (1) is intensively dissipated to the gap space (G). The heat (Q) generated during charging and discharging of the multiple secondary batteries (1) has been dispersed through a plurality of blower fans (60, 70) installed in the charging space (11). The blower fans (60, 70) have blown the air of the charging space (11).

If the temperature of the charging space (11) is increased by the heat (Q) generated during charging and discharging of the secondary battery (1), the temperature of the wind from the blower fans (60, 70) is also increased. If the temperature of the charging space (11) is increased by the heat (Q) generated during charging of the secondary battery (1), the temperature of the wind from the blower fan (60, 70) is also increased, whereby the heat exchange efficiency with the secondary battery (1) can be lowered.

In the conventional activation device, the plurality of blower fans (60, 70) blows wind to the upper portion of the tray (20) and the rear surface of the tray (20). In the conventional activation device, the wind from the blower fans (60, 70) has mainly flowed to an outer bailey part of the tray (20) and has difficultly flowed to the gap space (G) in the center part of the tray (20). The respective gap spaces (G) are each a space arranged between two secondary batteries (1) along the arrangement direction (W) of the secondary batteries (1).

Since the wind of the blower fans (60, 70) difficultly flows to the center part of the tray (20), a temperature deviation occurs between the secondary battery (1) accommodated in the outer bailey part of the tray (20) and the secondary battery (1) accommodated in the center part of the tray (20) during charging the secondary battery (1).

The conventional activation device operates in a state where it does not fundamentally remove the heat (Q) generated from the secondary battery (1) during the charging and discharging process, whereby the temperature control is difficult upon charging the secondary battery (1).

In addition, after repeating aging, charging, and discharging, the capacity of the secondary battery (1) is checked, and the low voltage of the secondary battery (1) is selected through the OCV (Open-Circuit Voltage) measurement of the secondary battery (1). The low voltage selection of the secondary battery (1) is a process performed for checking whether the secondary battery (1) maintains a normal voltage range upon charging or discharging.

The temperature deviation between multiple secondary batteries (1) occurring upon charging and discharging of the secondary battery (1) affects the capacity and OCV (Open-Circuit Voltage) of the secondary battery (1). If the secondary battery (1) is in a low voltage state, the secondary battery (1) does not operate properly or has a defect with a short lifespan. The low voltage secondary battery (1) has a risk to be internally ignited upon overcharge or overdischarge.

### Disclosure

### Technical Problem

The present invention has been devised to solve such problems, which is intended to provide a secondary battery charging and discharging device capable of eliminating temperature deviations between multiple secondary batteries by flowing cooling air into gap spaces of a tray in which the multiple secondary batteries are accommodated, thereby uniformly cooling the multiple secondary batteries.

Through one example of the present invention, it is intended to provide a secondary battery charging and discharging device capable of easily generating cold air for cooling in a chamber where secondary battery charging and discharging are performed, and controlling the temperature of the cold air.

Through one example of the present invention, it is intended to provide a secondary battery charging and discharging device capable of performing effective cooling by supplying cold air in a longitudinal direction of a gap space formed between secondary batteries, i.e., in a longitudinal direction of the secondary battery.

Through one example of the present invention, it is intended to provide a secondary battery charging and discharging device capable of effectively supplying cold air to gap spaces between secondary batteries by forming a forced downward cold air current toward one side of the secondary battery, and forming a forced suction air current at the other side of the secondary battery.

### Technical Solution

To achieve the purposes as described above, the secondary battery charging and discharging device has the following constitutions and structures.

In order to achieve the above-described purposes, a secondary battery charging and discharging device according to one example of the present invention may comprise a chamber including one or more charging spaces capable of individually accommodating trays, in which secondary batteries are accommodated, and mounted with charging grippers arranged to be electrically connectable with the secondary batteries in each charging space, a thermoelectric cooling part including a thermoelectric element, and cooling fins arranged to transfer cold air from a cooling side of the thermoelectric element to surroundings, and arranged to cool air in the charging space at an upper portion of the tray, and a first fan arranged to suck cooling air from the surroundings of the thermoelectric cooling part and to blow the cooling air into the secondary batteries accommodated in the tray and gap spaces which are surroundings of the secondary batteries.

Also, according to one example of the present invention, a secondary battery charging and discharging device may be provided, which comprises a chamber including one or more charging spaces capable of individually accommodating trays, in which secondary batteries are accommodated, and provided with charging grippers arranged to be electrically connectable with the secondary batteries in the charging space, a thermoelectric cooling part including a thermoelectric element, and cooling fins arranged to transfer cold air from a cooling side of the thermoelectric element to surroundings, and arranged to cool air in the charging space at an upper portion of the charging space, a first fan provided to suck cooling air from the surroundings of the thermoelectric cooling part at an upper portion of the charging space and to blow the cooling air toward the secondary batteries accommodated in the tray, and a second fan provided so that the cooling air flows along the longitudinal direction of the secondary battery by sucking air in parallel with the longitudinal direction of the secondary battery at a lower portion of the charging space.

In addition, according to one example of the present invention, a secondary battery charging and discharging device may be provided, which comprises a chamber including one or more charging spaces capable of individually accommodating trays, in which secondary batteries are accommodated, and provided with charging grippers arranged to be electrically connectable with the secondary batteries in the charging space, a thermoelectric cooling part including a thermoelectric element, and cooling fins arranged to transfer cold air from a cooling side of the thermoelectric element to surroundings, and arranged to cool air in the charging space at an upper portion of one side of the charging space, a first fan provided to suck cooling air from the surroundings of the thermoelectric cooling part at an upper portion of one side of the charging space and to blow the cooling air toward one side of the secondary batteries accommodated in the tray, and a second fan provided so that the cooling air flows along the longitudinal direction of the secondary battery by sucking air in parallel with the longitudinal direction of the secondary battery at a lower portion of the other side of the charging space.

Furthermore, the first fan may be disposed at an upper portion of a first open side of the tray in which a first electrode lead of the secondary battery is exposed. The first fan may be arranged to exhaust the cooling air to the first open side of the tray. For example, the first fan may be arranged to exhaust the cooling air to the first open side of the tray in a linear flow parallel to the arrangement direction of the secondary batteries.

In addition, the first fan may comprise a first blade, a first suction port, and a first exhaust port arranged in a slit shape on a side other than the first suction port. The first exhaust port may be arranged in a slit shape in parallel with the first blade. The first fan may exhaust the cooling air to the first open side through the first exhaust port by traversing it in a direction parallel to the arrangement direction upon rotation of the first blade.

As one example, the first fan may comprise a cross flow fan.

In addition, the second fan may be disposed diagonally with the first fan along the longitudinal direction and the height direction.

As one example, the second fan may be arranged to be fluidly movable with gap spaces of the tray through a second open side of the tray where a second electrode lead of the secondary battery is exposed, and to suck the cooling air from the first open side to the second open side along the longitudinal direction of the secondary battery. In this document, the upper portion of one side of the charging space may represent the upper portion of the first open side of the tray where the first electrode lead of the secondary battery is exposed, and the upper portion of the other side of the charging space may represent the upper portion of the second open side of the tray where the second electrode lead of the secondary battery is exposed.

In addition, the thermoelectric cooling part may be disposed at an upper portion of one side of the charging space, and the first fan may be provided to suck cooling air around the thermoelectric cooling part at the upper portion of one side of the charging space and to blow the cooling air toward one side of the secondary battery accommodated in the tray, and the second fan may be arranged to suck air in parallel with the longitudinal direction of the secondary battery at a lower portion of the other side of the charging space.

The second fan may be arranged to suck cooling air heat-exchanged in the gap spaces along the longitudinal direction and to exhaust the heat-exchanged cooling air to the outside of the charging space in a direction different from the longitudinal direction.

In addition, the secondary battery charging and discharging device may comprise a fan hood connecting the second suction port of the second fan and the second open side of the tray to be fluidly movable. The fan hood may expand suction force of the second fan to each gap space spaced apart in the arrangement direction of the secondary batteries. The fan hood may be arranged to guide the flow of the heat-exchanged cooling air of each gap space to the second suction port.

The fan hood may be disposed to be spaced apart from the lower portion of the charging gripper electrically connected to the secondary battery.

Also, the secondary battery charging and discharging device may comprise a temperature sensor arranged to sense the temperature of the cooling air heat-exchanged with the secondary battery in the charging space.

In addition, the secondary battery charging and discharging device may comprise a controller controlling operation of the thermoelectric cooling part and the first fan based on the temperature information of the temperature sensor.

The thermoelectric cooling part may comprise heat dissipation fins arranged to transfer hot air from the heat generation side of the thermoelectric element to the surroundings.

Also, the secondary battery charging and discharging device may comprise a third fan mounted in the chamber to suck heated air around the heat dissipation fins of the thermoelectric cooling part in the charging space, thereby exhausting it to a chamber duct outside the charging space.

In addition, the secondary battery charging and discharging device may comprise an exhaust duct installed in the charging space at the upper portion of the tray, and the thermoelectric cooling part may be mounted in the exhaust duct such that the heat dissipation fins are exposed to a duct space of the exhaust duct and the cooling fins are exposed to the charging space from the outer surface of the exhaust duct.

The heat dissipation fins may be disposed to be in parallel with the flow direction of heated air in the duct space.

The thermoelectric cooling part may be arranged such that the arrangement direction of the heat dissipation fins and the arrangement direction of the cooling fins are orthogonal.

The exhaust duct may be mounted in the chamber to be fluidly movable with the chamber duct in which the duct space is partitioned from the charging space, and may comprise a duct fan arranged to exhaust heated air of the duct space to the chamber duct by being mounted at the outlet of the exhaust duct.

In addition, the secondary battery charging and discharging device may comprise a heat dissipation part having heat dissipation fins and installed outside the charging space, and a heat pipe connecting the heat dissipation part and the thermoelectric cooling part and arranged to transfer heat of the thermoelectric cooling part to the heat dissipation part.

The cooling fins and the first fan may be provided inside the charging space. Particularly, they may be provided at the upper portion of one side of the charging space. In addition, the front surface of the chamber may be opened, through which the tray in which secondary batteries are accommodated may be inserted and removed. Then, by an air discharge pressure of the first fan, the outside air may be introduced between the first fan and the cooling fins through the front upper portion of the chamber and cooled.

The cooling temperature of the cooling fins may be controlled through control of the thermoelectric element. Therefore, the temperature of the cooling air may be controlled. Therefore, even if a separate refrigeration cycle is not provided, the controllable cooling air may be generated and supplied very simply within the charging space.

Meanwhile, a plurality of secondary batteries may be provided in parallel on the tray. Therefore, the gap spaces between the secondary batteries may also form a plurality of lanes. The cooling air needs to be supplied and discharged evenly to the plurality of lanes.

To this end, it is preferable that the first fan is a cross flow fan for evenly supplying cold air to all the inlets of the plurality of lanes. In addition, it is preferable that a duct is provided at the front end of the second fan for evenly sucking air from all the outlets of the plurality of lanes.

Through positional characteristics of the cooling fins of the thermoelectric element, and the first and second fans, a secondary battery charging and discharging device capable of providing compact, controllable, and effective cooling performance can be provided.

### Advantageous Effects

The secondary battery charging and discharging device having the constitutions and structures as described above has the following effects.

The secondary battery charging and discharging device can eliminate temperature deviations between multiple secondary batteries according to their positions accommodated in a tray upon charging and discharging of the secondary batteries by flowing cooling air into gap spaces of the tray, in which the multiple secondary batteries are accommodated, to uniformly cool the multiple secondary batteries.

Also, the secondary battery charging and discharging device can eliminate temperature deviations between multiple secondary batteries that are charged and discharged under the same conditions, thereby achieving homogenization of the performance and capacity of the multiple secondary batteries, and improving low-voltage selection capability of the secondary battery as well.

In addition, the secondary battery charging and discharging device can flow the cooling air into the gap spaces of the tray through two fans, i.e., a first fan and a second fan, thereby achieving compactification of the device.

Furthermore, the secondary battery charging and discharging device can exhaust the cooling air heat-exchanged with the secondary battery in the charging space to an activation room to lower the temperature of the activation room, thereby saving air conditioning costs for temperature control of the activation room.

Also, the secondary battery charging and discharging device can exhaust the heated air that has absorbed the heat generated in a process of cooling the air in the charging space to the chamber duct, thereby improving the air conditioning efficiency in the charging space.

In addition, the secondary battery charging and discharging device can charge and discharge the plurality of secondary batteries under optimized conditions by adjusting a cooling temperature of a thermoelectric cooling part to a preset temperature based on the temperature information of the cooling air heat-exchanged in the charging space, thereby improving the capacity and performance of the secondary battery.

### Description of Drawings

Figure 1 is a diagram for explaining a pouch-type secondary battery.
Figures 2 and 3 are diagrams for explaining wind flows upon operation of a blower fan in a conventional secondary battery charging and discharging device, wherein Figure 2 schematically illustrates a perspective diagram of a charging and discharging device having a tray, in which multiple secondary batteries are accommodated, and a charging space, and Figure 3 schematically illustrates a plan view of a charging space in which a tray is inserted.
Figures 4 to 7 are diagrams for explaining a secondary battery charging and discharging device according to a first example of the present invention.

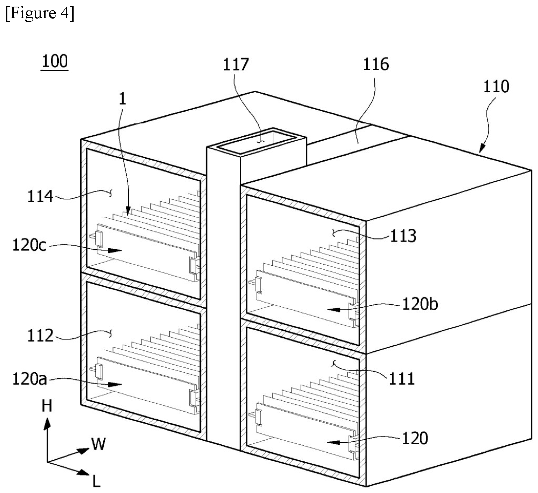

Figure 4 schematically illustrates a state where trays are accommodated in a chamber according to the first example of the present invention.

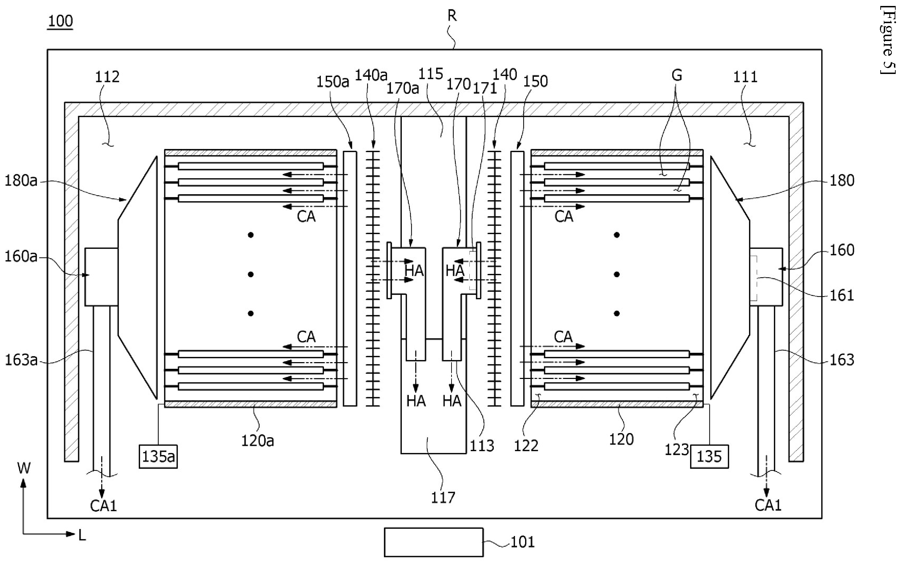

Figure 5 schematically illustrates a plan view of a secondary battery charging and discharging device according to a first example of the present invention.

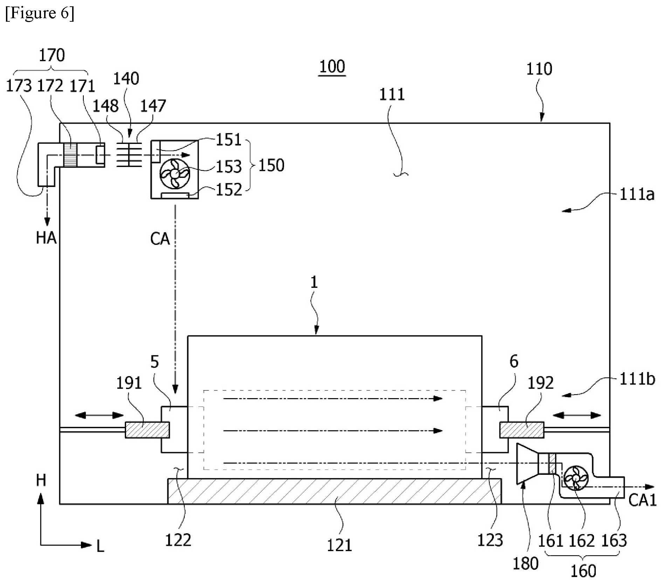

Figure 6 schematically illustrates a side view of a secondary battery charging and discharging device according to a first example of the present invention.

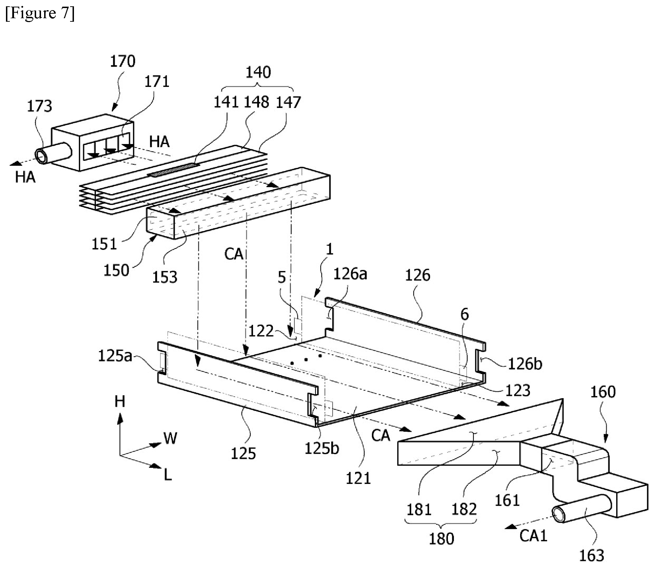

Figure 7 is a diagram for explaining arrangement of a first fan, a second fan, and a third fan for a tray and air flows according to a first example of the present invention.

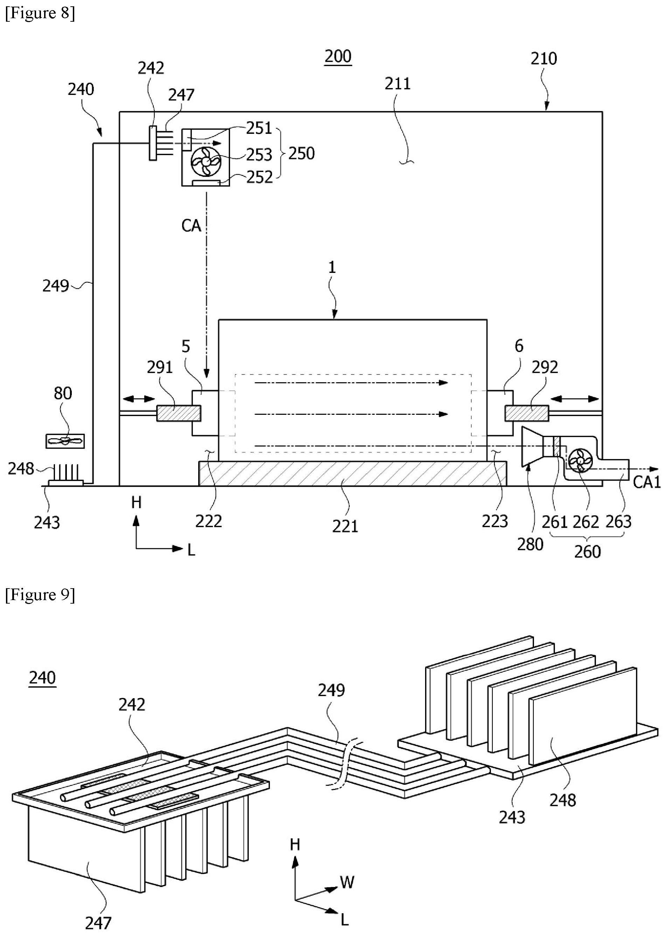

Figures 8 and 9 are diagrams for explaining a secondary battery charging and discharging device according to a second example of the present invention.

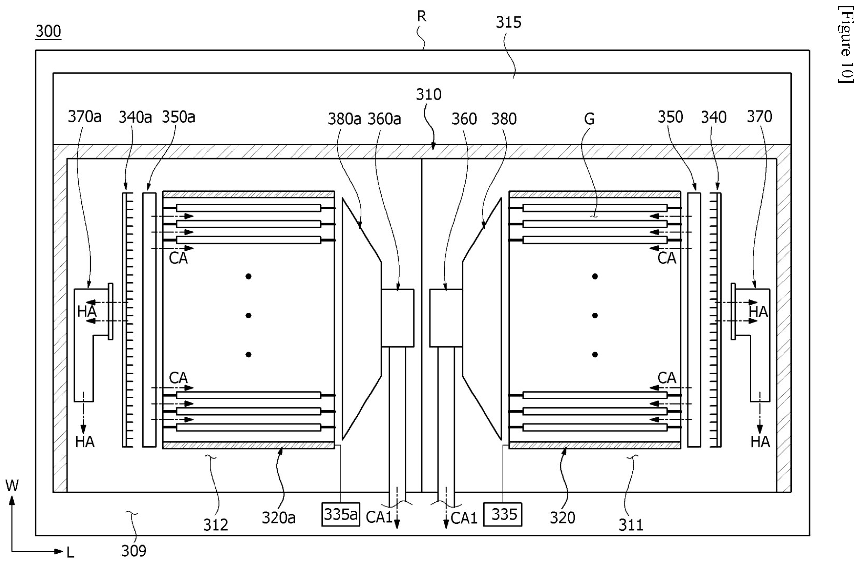

Figure 10 is a diagram for explaining a secondary battery charging and discharging device according to a third example of the present invention.

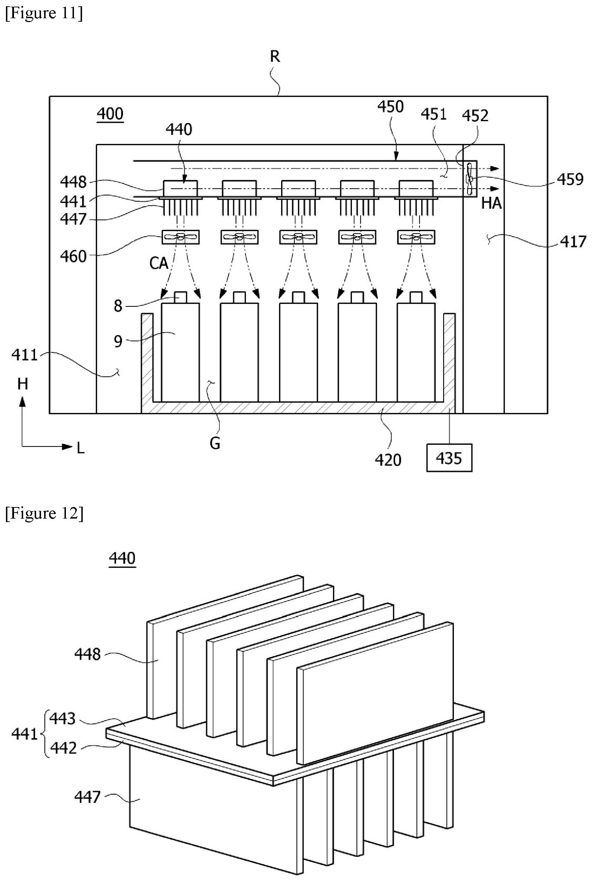

Figures 11 and 12 are diagrams for explaining a secondary battery charging and discharging device according to a fourth example of the present invention.

### Mode for Invention

Hereinafter, with reference to the attached drawings, a secondary battery charging and discharging device according to one example of the present invention will be described.

Figures 4 to 7 are diagrams for explaining a secondary battery charging and discharging device according to a first example of the present invention, wherein Figure 4 schematically illustrates a state where trays are accommodated in a chamber, Figure 5 schematically illustrates a plan view of a secondary battery charging and discharging device, Figure 6 schematically illustrates a side view of a secondary battery charging and discharging device, and Figure 7 is a diagram for explaining arrangement of a first fan, a second fan, and a third fan for a tray and air flows according to a first example of the present invention.

The secondary battery charging and discharging device (100) related to the first example of the present invention comprises a chamber (110) including one or more charging spaces (111, 112, 113, 114) capable of individually accommodating trays (120), in which secondary batteries (1) are accommodated, and provided with charging grippers (191, 192) arranged to be electrically connectable with the secondary batteries (1) in each charging space (111, 112, 113, 114). In addition, a tray (120, 120a, 120b, 120c) may be accommodated in each charging space (111, 112, 113, 114).

Also, the secondary battery charging and discharging device (100) comprises a thermoelectric cooling part (240) including a thermoelectric element (141) and cooling fins (147) arranged to transfer cold air from a cooling side of the thermoelectric element (141) to surroundings, and arranged to cool air in the charging space (111) at an upper portion of the tray (120).

In addition, the secondary battery charging and discharging device (100) comprises a first fan (150) provided to suck cooling air (CA) from the surroundings of the thermoelectric cooling part (240) and to blow the cooling air (CA) to the secondary batteries (1) accommodated in the tray (120) and gap spaces (G) which are surroundings of the secondary batteries (1).

In this document, a symbol H represents a height direction, a symbol L represents a longitudinal direction of the secondary battery, and a symbol W represents an arrangement direction of the secondary batteries on the tray.

The chamber (110) is installed in an activation room (R). The chamber (110) is arranged so that each charging space (111, 112, 113, 114) is opened to the outside. The chamber (110) may have a multi-layer structure in which two or more charging spaces (111, 112, 113, 114) are disposed to be spaced apart therefrom along the height direction (H).

The chamber (110) may comprise a power supply part (115) for supplying electricity to the charging grippers (191, 192) of first-layer charging spaces (111 and 112), and a power supply part (116) for supplying electricity to the charging grippers (191, 192) of second-layer charging spaces (113 and 114) for each layer.

The chamber (110) is arranged with a chamber duct (117) between two charging spaces (111). The chamber duct (117) extends in the height direction (H) of the chamber (110), which may be connected to be fluidly movable with the respective charging spaces (111, 112, 113, 114) and the power supply parts (115, 116).

The secondary battery (1) may comprise a first electrode lead (5) and a second electrode lead (6) spaced apart from the first electrode lead (5) in the longitudinal direction (L) of the secondary battery (1). The secondary battery (1) according to the present example may be a pouch-type secondary battery (1) as illustrated in Figure 1.

The tray (120) has an open box structure having a tray bottom surface (121), a first support (125), and a second support (126). The tray (120) has a first open side (122) and a second open side (123).

The first open side (122) is an open portion between one side of the first support (125) and one side of the second support (126). The second open side (123) is an open portion between the other side of the first support (125) and the other side of the second support (126). The second open side (123) faces the first open side (122).

The first support (125) may have a first hole (125a) and a second hole (125b). In addition, the second support (126) may have a third hole (126a) and a fourth hole (126b). The first hole (125a) and the third hole (126a) are openings connected to the first open side (122) of the tray. The second hole (125b) and the fourth hole (126b) are openings connected to the second open side (123) of the tray.

Each secondary battery (1) is accommodated in the tray (120) so that the first electrode lead (5) is exposed to the first open side (122) and the second electrode lead (6) is exposed to the second open side (123), between the first support (125) and the second support (126). The multiple secondary batteries (1) are spaced apart from each other and accommodated in the tray (120) along the arrangement direction (W).

A plurality of gap spaces (G) is arranged in the tray (120) by the plurality of secondary batteries (1). The gap space (G) is a space between two adjacent secondary batteries (1) along the arrangement direction (W).

The charging gripper electrically connected to the secondary battery (1) in the charging device of the secondary battery (1) is a known technology, and thus, in the present example, the detailed constitutions and structures of the first charging gripper (191) and the second charging gripper (192) will be omitted.

The first charging gripper (191) enters the first open side (122) of the tray to be electrically connected to the first electrode lead (5) of the plurality of secondary batteries (1). Then, the second charging gripper (192) enters the second open side (123) of the tray to be electrically connected to the second electrode lead (6) of the plurality of secondary batteries (1).

The plurality of secondary batteries (1) may be accommodated in one tray (120), thereby being simultaneously charged and discharged in the charging space (111) of the chamber (110). The secondary batteries (1) generate heat by an electrochemical reaction during the charging and discharging process. The heat of the secondary batteries (1) is dissipated to adjacent gap spaces (G). The gap spaces (G) are heated due to the heat of the secondary batteries (1).

As the gap spaces (G) are heated, heat exchange between the heat of the secondary batteries (1) and the air in the gap spaces (G) is not performed smoothly. If the heat of the secondary batteries (1) is not properly dissipated, it causes a decrease in the performance and capacity of the secondary batteries (1).

In order to solve such a problem, the secondary battery charging and discharging device (100) can uniformly cool the temperature of a plurality of secondary batteries (1) that are simultaneously charged and discharged in the tray (120) through a thermoelectric cooling part (140) arranged to cool the air of the charging space (111) at the upper portion of the tray

(120), and a first fan (150) arranged to blow the cooling air (CA) to the secondary batteries (1) accommodated in the tray (120) and the gap spaces (G) which are surroundings of the secondary batteries (1).

The thermoelectric cooling part (140) is mounted in the charging space (111) to be spaced apart from the upper portion of the first open side (122) of the tray (120). The thermoelectric cooling part (140) is arranged to cool the air of the charging space (111). The thermoelectric cooling part (140) comprises a thermoelectric element (141), a plurality of cooling fins (147), and a plurality of heat dissipation fins (148).

The thermoelectric element (141) is an electric element having two conductors made of different metals, and arranged for one conductor to absorb surrounding heat and for the other conductor to release heat to the surroundings, upon electric current application. For example, the thermoelectric element (141) may be a Peltier element.

The plurality of cooling fins (147) is mounted on the cooling side of the thermoelectric element (141), and absorbs surrounding heat. The plurality of heat dissipation fins (148) is mounted on the heat generation side of the thermoelectric element (141), and releases heat to the surroundings.

The cooling fins (147) and the heat dissipation fins (148) may have a metal with excellent thermal conductivity, for example, a copper or aluminum material.

The first fan (150) may be disposed at the upper portion (111a) of the charging space (111). Specifically, the first fan (150) is disposed at the upper portion (111a) of the first open side (122) of the tray (120) where the first electrode lead (5) of the secondary battery (1) is exposed. The first fan (150) may be arranged to exhaust the cooling air (CA) to the first open side (122) of the tray (120) in a linear flow parallel to the arrangement direction (W) of the secondary battery (1).

The first fan (150) may be a rod-shaped fan. The first fan (150) may comprise a cross flow fan.

The first fan (150) comprises a first blade (153), a first suction port (151), and a first exhaust port (152) arranged in a slit shape to be parallel to the first blade (153) on a side other than the first suction port (151).

The first exhaust port (152) is an opening on a side other than the first suction port (151). The first exhaust port (152) is a slit opening having a rectangular cross-section with a long length and a narrow width.

The first fan (150) is arranged such that the first suction port (151) faces the cooling side of the thermoelectric cooling part (140), and the first exhaust port (152) faces the first open side (122) of the tray (120).

The first fan (150) may traverse the cooling air (CA) in a direction parallel to the arrangement direction (W) upon rotation of the first blade (153), and exhaust the cooling air (CA) to the first open side (122) through the first exhaust port (153).

The cooling air (CA) may be blown downward toward the first open side (122) of the tray (120) along the height direction (H) in a linear flow parallel to the arrangement direction (W) of the secondary battery (1) through the first fan (150).

In addition, the secondary battery charging and discharging device (100) may install a second fan (160) on the second open side (123) of the tray, thereby flowing the cooling air (CA) from the first open side (122) to the second open side (123) along the longitudinal direction (L) of the secondary battery (1).

The second fan (160) is installed in the charging space (111) to be fluidly movable with the second open side (123) of the tray (120). The second fan (160) may be disposed in the lower portion (111b) of the charging space (111). The second fan (160) is arranged to suck the cooling air (CA) from the first open side (122) to the second open side (123) along the longitudinal direction (L) of the secondary battery (1).

The second open side (123) of the tray (120) is a portion where the second electrode lead (6) of the plurality of secondary batteries (1) is exposed. The second open side (123) of the tray (120) is a portion opened to face the first open side (122) of the tray (120) along the longitudinal direction (L) of the secondary battery (1).

The second fan (160) may be disposed diagonally with the first fan (150) along the longitudinal direction (L) and the height direction (H).

The second fan (160) may be arranged to suck the cooling air (CA1) that has been heat-exchanged in the gap spaces (G) along the longitudinal direction (L) and to exhaust the heat-exchanged cooling air (CA1) to the outside of the charging space (111) in a direction different from the longitudinal direction (L).

The second fan (160) comprises a second suction port (161), a second blade (162), and a second exhaust port (163). The second fan (160) is disposed such that the second suction port (161) is fluidly movable with the second open side (123) of the tray (120), and mounted such in the chamber (110) that the second exhaust port (163) is fluidly movable with the outside of the charging space (111). The second fan (160) may comprise a centrifugal fan.

Upon operation of the second fan (160), the cooling air (CA) may heat-exchange with the plurality of secondary batteries (1) while flowing each gap space (G) from the first open side (122) of the tray (120) toward the second open side (123). The heat-exchanged cooling air (CA1) may be sucked into the charging space (111) through the second suction port (161) and exhausted to the outside of the charging space (111) through the second fan (160).

A fan hood (180) may be mounted on the second suction port (161) of the second fan (160).

The fan hood (180) may expand the suction force of the second fan (160) to a plurality of gap spaces (G) spaced apart in the arrangement direction (W) of the secondary batteries (1).

The fan hood (180) is arranged to guide the flow of heat-exchanged cooling air (CA1) of each gap space (G) to the second suction port (161).

The fan hood (180) connects the second suction port (161) of the second fan (160) and the second open side (123) of the tray (120) to be fluidly movable with each other, and is disposed at the lower portion (111b) of the charging space (111) parallel to the arrangement direction (W) of the secondary battery (1).

The fan hood (180) may guide the flow of heat-exchanged cooling air (CA1) from each gap space (G) in the tray (120) to the second suction port (161) upon operation of the second fan (160).

The fan hood (180) has a funnel structure. The fan hood (180) has a hood opening (181) and a hood passage (182). The hood opening (181) has a width greater than the width of the tray (120) and a height less than the height of the tray (120). The hood passage (182) is arranged so that the cross-sectional area becomes narrower from the hood opening (181) toward the second suction port (161) of the second fan (160).

The fan hood (180) may be disposed so that the hood opening (181) is parallel to the arrangement direction (W) of the secondary battery (1). The fan hood (180) may be disposed at the lower portion of the second charging gripper (192). The fan hood (180) may be disposed at the lower portion (111b) of the charging space (111) between the second open side (123) of the tray (120) and the second charging gripper (192). As one example, the second fan (160) may be disposed at the lower portion (111b) of the charging space (111) between the second open side (123) and the second charging gripper (192).

The secondary battery charging and discharging device (100) having such constitutions and structures evenly blows cooling air (CA) through the first fan (150) into a plurality of gap spaces (G) in a linear flow parallel to the arrangement direction (W) of the secondary battery, and sucks the cooling air (CA) in the longitudinal direction (L) of the secondary battery through the second fan (160), whereby the cooling air (CA) can flow from the first open side (122) of the tray (120) toward the second open side (123) in each gap space (G).

Through this, the secondary battery charging and discharging device (100) can uniformly adjust the temperature of the plurality of secondary batteries (1) upon charging and discharging the plurality of secondary batteries (1). Also, the secondary battery charging and discharging device (100) can achieve homogenization of the performance and capacity of the plurality of secondary batteries (1) accommodated in one tray (120). In addition, the secondary battery charging and discharging device (100) can exhaust the heat-exchanged cooling air (CA1) to the outside of the charging space (111), thereby reducing the air conditioning cost of the activation room (R).

In addition, the secondary battery charging and discharging device (100) can improve the cooling efficiency of the charging space (111) by installing a third fan (170) on the heat generation side of the thermoelectric cooling part (140).

The third fan (170) is disposed around the heat generation side of the thermoelectric cooling part (140) on the opposite side of the first fan (150). The third fan (170) is arranged to suck heated air (HA) from the heat generation side of the thermoelectric cooling part (140) at the upper portion of the charging space (111) and to exhaust the heated air (HA) to the outside of the charging space (111). The third fan (170) may comprise a centrifugal fan.

The third fan (170) comprises a third suction port (171), a third blade (172), and a third exhaust port (173).

The third fan (170) may be mounted in the chamber (110) so that the third suction port (171) is disposed around the heat-generating side of the thermoelectric cooling part (140), and the third exhaust port (173) is fluidly movable with the chamber duct (117).

Upon operation of the third fan (170), the heated air (HA) is sucked into the internal space of the third fan (170) through the third suction port (171) and exhausted through the third blade (172) to the third exhaust port (173). The heated air (HA) is exhausted to the chamber duct (117) through the third exhaust port (173).

The chamber duct (117) is a duct arranged to be separated from the charging space (111). The chamber duct (117) is a duct arranged to exhaust the heated air (HA) to the outside of the activation room (R).

Also, the secondary battery charging and discharging device (100) may comprise temperature sensors (135, 135a) arranged to sense the temperature of the cooling air (CA1) heat-exchanged with the secondary battery (1) in the charging space (111). The temperature sensors may be provided in each charging space.

In addition, the secondary battery charging and discharging device (100) may comprise a controller (101) controlling operation of the thermoelectric cooling part (140) and the first fan (150) based on the temperature information of the temperature sensors (135, 135a).

The temperature sensor (135) may be mounted around the second open side (123) of the tray (120) to sense the temperature of the heat-exchanged cooling air (CA1).

The controller (101) may control the operation of each of the thermoelectric cooling part (140, 140a), the first fan (150, 150a), the second fan (160, 160a), and the third fan (170, 170a) so that the temperature in each charging space (111, 112) becomes a preset temperature based on the temperature information of the temperature sensors (135, 135a) provided in each charging space (111, 112).

For example, when the temperature of the heat-exchanged cooling air (CA1) as sensed by the temperature sensor (135) provided in any one charging space (111) is higher than the preset air conditioning temperature, the controller (101) can lower the cooling temperature of the thermoelectric cooling part (140) and strongly adjust the strength of the first fan (150) to the third fan (170).

When the temperature of the heat-exchanged cooling air (CA1) as sensed by the temperature sensor (135) is lower than the preset air conditioning temperature, the controller (101) can increase the cooling temperature of the thermoelectric cooling part (140) and weakly adjust the strength of the first fan (150) to the third fan (170).

Referring to Figure 5, the thermoelectric cooling part (140a), the first fan (150a), the second fan (160a), the third fan (170a), and the fan hood (180a) installed in another charging space (112) may be disposed symmetrically with the thermoelectric cooling part (140), the first fan (150), the second fan (160), the third fan (170), and the fan hood (180) installed in one charging space (111). In addition, in another charging space (112), a temperature sensor (135a) is mounted on the tray (120a) to sense the temperature of the heat-exchanged cooling air (CA1) flowing to the second fan (160a).

The heated air (HA) of one charging space (111) may be exhausted to the chamber duct (117) through the third fan (170), and the heated air (HA) of the other charging space (112) may be exhausted to the chamber duct (117) through the third fan (170a).

The cooling air (CA1) heat-exchanged in one charging space (111) is exhausted to the activation room (R) through the second exhaust port (163) of the second fan (160), and the cooling air (CA1) heat-exchanged in another charging space (112) is exhausted to the activation room (R) through the second exhaust port (163a) of the second fan (160a). The heat-exchanged cooling air (CA1) is exhausted from each charging space (111, 112) to the activation room (R), thereby enabling to lower the temperature of the activation room (R).

The secondary battery charging and discharging device (100) can achieve homogenization of the performance and capacity of the plurality of secondary batteries (1) by eliminating the temperature deviation between the plurality of secondary batteries (1).

In addition, the secondary battery charging and discharging device (100) can reduce the temperature dispersion between the plurality of secondary batteries (1), thereby improving the low-voltage selection efficiency, by maintaining the temperature of the plurality of secondary batteries (1) uniformly upon charging the secondary battery (1).

Figures 8 and 9 are diagrams for explaining a secondary battery charging and discharging device according to a second example of the present invention.

Hereinafter, the secondary battery charging and discharging device according to the second example of the present invention will be described with reference to Figures 8 and 9.

The secondary battery charging and discharging device (200) according to the second example may comprise a chamber (210) having at least one charging space (211), a pair of charging grippers (291, 292), a thermoelectric cooling part (240), a temperature sensor, a first fan (250), and a second fan (260). In addition, the secondary battery charging and discharging device (200) may comprise a fan hood (280).

The pair of charging grippers (291, 292), the thermoelectric cooling part (240), the temperature sensor, the first fan (250), and the second fan (260) are mounted in each charging space (211). A tray (220) in which multiple secondary batteries (1) are accommodated is accommodated in the charging space (211).

The tray (220), the chamber (210), the pair of charging grippers (291, 292), the temperature sensor, the first fan (250), and the second fan (260), according to the present example, have the same functions and structures as those of the tray (120), the chamber (110), the pair of charging grippers (191, 192), the temperature sensor (135), the first fan (150), and the second fan (160) of the first example as described above.

To avoid repetition of explanation in the present example, a thermoelectric cooling part (240) different from the first example as described above will be described.

Referring to Figures 8 and 9, the thermoelectric cooling part (240) comprises a cooling side (242) of the thermoelectric cooling part, a heat dissipation part (243), and a heat pipe (249).

The cooling side (242) of the thermoelectric cooling part comprises a plurality of cooling fins (247). The cooling side (242) of the thermoelectric cooling part is mounted in the charging space (211), and absorbs surrounding heat through the plurality of cooling fins (247) upon electric current application.

The heat dissipation part (243) comprises a plurality of heat dissipation fins (248). The heat dissipation part (243) is mounted in the chamber (210) outside the charging space (211). The heat dissipation part (243) releases heat transferred from the heat pipe (249) to the surroundings through the plurality of heat dissipation fins (248). To disperse heated air (HA) around the heat dissipation fins (248), a blower fan (80) may be installed around the plurality of heat dissipation fins (248).

The heat pipe (249) connects the cooling side (242) of the thermoelectric cooling part and the heat dissipation part (243). The heat pipe (249) may transfer heat from the cooling side (242) of the thermoelectric cooling part to the heat dissipation part (243). The heat pipe (249) may have a copper or aluminum material with excellent thermal conductivity.

The heat pipe (249) transfers heat from the cooling side (242) of the thermoelectric cooling part to the heat dissipation part (243) through a working fluid. In the heat pipe (249), the working fluid is heated by the heat of the cooling side (242) of the thermoelectric cooling part and becomes a gaseous state. The gaseous working fluid flows from the cooling side (242) of the thermoelectric cooling part to the heat dissipation part (243) along the heat pipe (249), and condenses into a liquid state while releasing heat from the heat dissipation part (243). The liquid working fluid flows to the cooling side (242) of the thermoelectric cooling part along the heat pipe (249).

The heat generated during the operation of the cooling side (242) of the thermoelectric cooling part is transferred to the heat dissipation part (243) through the heat pipe (249). The heat released from the heat dissipation part (243) is dispersed to the surroundings by the wind to be blown to the plurality of heat dissipation fins (248).

The cold air generated on the cooling side (242) of the thermoelectric cooling part is exhausted to the first open side (222) of the tray (220) through the first fan (250). The first fan (250) comprises a first blade (253), a first suction port (251), and a first exhaust port (252). Then, the cooling air (CA) heat-exchanges with the secondary batteries (1) while flowing from the first open side (222) of the tray (220) to the second open side (223) along the longitudinal direction (L) of the secondary battery (1) through the second fan (260). The second fan (260) comprises a second suction port (261), a second blade (262), and a second exhaust port (263). The heat-exchanged cooling air (CA1) may be exhausted to the activation room (R) outside the charging space (211) through the second fan (260).

The secondary battery charging and discharging device (200) can cool the heat generated during charging and discharging of the plurality of secondary batteries (1) through the structure and operation method as described above. The secondary battery charging and discharging device (200) can eliminate the temperature deviation between the plurality of secondary batteries (1) during charging of the secondary batteries (1), thereby achieving homogenization of the performance and capacity of the plurality of secondary batteries (1).

Hereinafter, with reference to Figure 10, a secondary battery charging and discharging device according to a third example of the present invention will be described.

Figure 10 is a diagram for explaining a secondary battery charging and discharging device (300) according to a third example of the present invention.

A secondary battery charging and discharging device (300) according to a third example comprises a chamber (310) having at least one charging space (311, 312), a pair of charging grippers (not shown), a temperature sensor (335, 335a), a thermoelectric cooling part (340, 340a), a first fan (350, 350a), a second fan (360, 360a), and a third fan (370, 370a). In addition, the secondary battery charging and discharging device (300) may comprise a fan hood (380, 380a).

The temperature sensor (335, 335a), the thermoelectric cooling part (340, 340a), the first fan (350, 350a), the second fan (360, 360a), and the third fan (370, 370a) according to the third example have the same structures and functions as those of the temperature sensor (135, 135a), the thermoelectric cooling part (140, 140a), the first fan (150, 150a), the second fan (160, 160a), and the third fan (170, 170a) according to the first example as described above, so that the detailed descriptions thereof will be omitted in the present example to avoid repetition of explanation.

The chamber (110) according to the first example as described above has a structure in which a power supply part (115) and a chamber duct (117) are disposed between two adjacent charging spaces (111, 112), whereas the chamber (310) according to the third example has a structure in which multiple charging spaces (311, 312) are disposed continuously for each layer.

The chamber (310) is arranged so that the charging spaces (311, 312) are fluidly movable with the room passage of the activation room (R). In the chamber (310) according to the present example, the power supply part (315) may be installed on the opposite side of the entry side of the charging space (311, 312) through which the tray (320, 320a) enters the charging space (311, 312).

The power supply part (315) is electrically connected to a pair of charging grippers (not shown) mounted in the charging space (311, 312) at the rear surface of the charging space (311, 312). The arrangement of the pair of charging grippers (not shown) is the same as in the first example as described above.

The thermoelectric cooling part (340) cools the air in the charging space (311) to a preset cooling temperature. The cooling air (CA) is blown toward the first open side of the tray (320) parallel to the arrangement direction (W) of the secondary batteries (1) through the first fan (350).

Upon operation of the first fan (350) and the second fan (360), the cooling air (CA) flows along each gap space (G) between the plurality of secondary batteries. The cooling air (CA) heat-exchanges with the secondary batteries (1) while flowing from the first open side of the tray (320) to the second open side along the longitudinal direction (L) of the secondary battery in each gap space (G). The heat-exchanged cooling air (CA1) may be exhausted to the passage (309) of the activation room (R), which is the outside of the charging space (311), through the second fan (360).

Upon operation of the thermoelectric cooling part (340), the heat generated in the thermoelectric cooling part (340) may be exhausted to the activation room (R), which is the outside of the charging space (311), through the third fan (370).

Hereinafter, with reference to Figures 11 and 12, a secondary battery charging and discharging device according to a fourth example of the present invention will be described.

Figures 11 and 12 are diagrams for explaining a secondary battery charging and discharging device according to a fourth example of the present invention.

The secondary battery charging and discharging device (400) according to the present example comprises a chamber (410) having at least one charging space (411), a thermoelectric cooling part (440), a temperature sensor (435), an exhaust duct (450), a duct fan (459), and a plurality of blower fans (460).

The chamber (410) may have the same structure as the chamber (110) of the first example as described above. The chamber (410) is mounted with a pair of charging grippers (not shown) for each charging space (411), and is arranged to perform charging and discharging for the plurality of secondary batteries (1) for each charging space (411).

The multiple secondary batteries (9) are spaced apart and accommodated in a tray (420) to have gap spaces (G). For example, the secondary battery (9) may be a cylindrical battery cell. The secondary battery (9) is accommodated upright in the tray (420) so that the positive terminal (8) having the vent part is exposed to the upper portion of the tray (420).

The plurality of secondary batteries (9) may be simultaneously charged in the charging space (411). In this example, descriptions of the constitutions of a charging gripper (not shown) electrically connected to the plurality of secondary batteries (9) and a power supply part (not shown) supplying electricity to the charging gripper will be omitted.

The exhaust duct (450) is mounted in each charging space (411) of the chamber (410). The exhaust duct (450) is disposed to be spaced apart from the upper portion of the tray (420). The exhaust duct (450) is connected to be fluidly movable with the chamber duct (417).

A duct fan (459) is mounted at the outlet (452) of the exhaust duct (450). The duct fan (459) is arranged to exhaust heated air (HA) of the duct space (451) to the chamber duct (117).

The thermoelectric cooling part (440) is mounted in the exhaust duct (450). Referring to Figure 11, the thermoelectric cooling part (440) comprises a thermoelectric element (441), a plurality of cooling fins (447) mounted on the cooling side (442) of the thermoelectric element (441), and a plurality of heat dissipation fins (448) mounted on the heat generation side (443) of the thermoelectric element (441).

The thermoelectric cooling part (240) may be mounted in the exhaust duct (450) so that the heat dissipation fins (148) are exposed to the duct space (451) of the exhaust duct (450) and the cooling fins (147) are exposed to the charging space (111) from the outer surface of the exhaust duct (450).

The thermoelectric cooling part (440) may be arranged so that the arrangement direction of the heat dissipation fins (448) and the arrangement direction of the cooling fins (447) are orthogonal. The heat dissipation fins (448) may be disposed parallel to the flow direction of the heated air (HA) of the duct space (451).

The blower fan (460) is disposed at the lower portion of the cooling fins (447). The blower fan (460) sucks the cooling air (CA) around the cooling fins (447) and blows it toward the tray (420). The cooling air (CA) flows through the gap space (G) which is a space between the plurality of secondary batteries (1) while being blown from the top to the bottom of the charging space (411) through the blower fan (460).

In the gap space (G), the cooling air (CA) may dissipate heat generated during charging and discharging of the secondary battery (1) while heat-exchanging heat with each secondary battery (1). The cooling air heat- exchanged while flowing through the gap space (G) may be exhausted to the activation room (R).

The plurality of heat dissipation fins (448) may be mounted on the heat generation side (443) of the thermoelectric element (441) to be orthogonal to the arrangement direction of the plurality of cooling fins (447). The plurality of heat dissipation fins (448) may be mounted in the duct space (451) to be parallel to the longitudinal direction (L) of the exhaust duct (450).

Upon operation of the thermoelectric cooling part (440), the heat generation side (443) of the thermoelectric element (441) releases heat to the plurality of heat dissipation fins (448).

Upon operation of the duct fan (459), the heated air (HA) around the heat dissipation fins (448) is exhausted to the chamber duct (417) through the exhaust duct (450) fan while flowing along the longitudinal direction (L) of the exhaust duct (450).

The secondary battery charging and discharging device (400) can cool the heat generated upon charging and discharging the plurality of secondary batteries (1) through the structures and operating methods as described above. The secondary battery charging and discharging device (400) can eliminate the temperature deviation between the plurality of secondary batteries (1) upon charging the secondary batteries (1), thereby achieving homogenization of the performance and capacity of the plurality of secondary batteries (1).

The preferred examples of the present invention as described above have been disclosed for illustrative purposes, and those skilled in the art having ordinary knowledge of the present invention will be able to make various modifications, changes, and additions within the spirit and scope of the present invention, and such modifications, changes, and additions should be regarded as falling within the scope of the following claims.

### Industrial Applicability

According to a secondary battery charging and discharging device related to one example of the present invention, multiple secondary batteries can be uniformly cooled by flowing cooling air into gap spaces of a tray in which the multiple secondary batteries are accommodated.

## Claims

1. A secondary battery charging and discharging device comprising:
a chamber including one or more charging spaces capable of individually accommodating trays, in which secondary batteries are accommodated, and provided with charging grippers arranged to be electrically connectable with the secondary batteries in the charging space;
a thermoelectric cooling part including a thermoelectric element, and cooling fins arranged to transfer cold air from a cooling side of the thermoelectric element to surroundings, and arranged to cool air in the charging space at an upper portion of the charging space;
a first fan provided to suck cooling air from the surroundings of the thermoelectric cooling part at an upper portion of the charging space and to blow the cooling air toward the secondary batteries accommodated in the tray; and
a second fan provided so that the cooling air flows along the longitudinal direction of the secondary battery by sucking air in parallel with the longitudinal direction of the secondary battery at a lower portion of the charging space.

2. The secondary battery charging and discharging device according to claim 1, wherein
the first fan is disposed at an upper portion of a first open side of the tray in which a first electrode lead of the secondary battery is exposed, and arranged to exhaust the cooling air to the first open side of the tray.

3. The secondary battery charging and discharging device according to claim 2, wherein
the first fan comprises a first blade, a first suction port, and a first exhaust port arranged in a slit shape on a side other than the first suction port, and
exhausts the cooling air to the first open side through the first exhaust port by traversing it in a direction parallel to the arrangement direction upon rotation of the first blade.

4. The secondary battery charging and discharging device according to claim 3, wherein
the first fan comprises a cross flow fan.

5. The secondary battery charging and discharging device according to claim 2, wherein
the second fan is arranged to be fluidly movable with gap spaces of the tray through a second open side of the tray where a second electrode lead of the secondary battery is exposed, and to suck the cooling air from the first open side to the second open side along the longitudinal direction of the secondary battery.

6. The secondary battery charging and discharging device according to claim 2, wherein
the thermoelectric cooling part is disposed at an upper portion of one side of the charging space,
the first fan is provided to suck cooling air around the thermoelectric cooling part at the upper portion of one side of the charging space and to blow the cooling air toward one side of the secondary battery accommodated in the tray, and
the second fan is arranged to suck air in parallel with the longitudinal direction of the secondary battery at a lower portion of the other side of the charging space.

7. The secondary battery charging and discharging device according to claim 5, wherein
the second fan is disposed diagonally with the first fan along the longitudinal direction and the height direction.

8. The secondary battery charging and discharging device according to claim 5, wherein
the second fan is arranged to suck cooling air heat-exchanged in the gap spaces along the longitudinal direction and to exhaust the heat-exchanged cooling air to the outside of the charging space in a direction different from the longitudinal direction.

9. The secondary battery charging and discharging device according to claim 5, further comprising
a fan hood connecting the second suction port of the second fan and the second open side of the tray to be fluidly movable, wherein
the fan hood is arranged to guide the flow of the heat-exchanged cooling air of each gap space to the second suction port.

10. The secondary battery charging and discharging device according to claim 9, wherein
the fan hood is disposed to be spaced apart from the lower portion of the charging gripper electrically connected to the secondary battery.

11. The secondary battery charging and discharging device according to claim 1, further comprising
a temperature sensor arranged to sense the temperature of the cooling air heat-exchanged with the secondary battery in the charging space.

12. The secondary battery charging and discharging device according to claim 11, further comprising
a controller controlling operation of the thermoelectric cooling part and the first fan based on the temperature information of the temperature sensor.

13. The secondary battery charging and discharging device according to claim 1, wherein
the thermoelectric cooling part further comprises heat dissipation fins arranged to transfer hot air from the heat generation side of the thermoelectric element to the surroundings.

14. The secondary battery charging and discharging device according to claim 13, further comprising
a third fan mounted in the chamber to suck heated air around the heat dissipation fins of the thermoelectric cooling part in the charging space, thereby exhausting it to a chamber duct outside the charging space.

15. The secondary battery charging and discharging device according to claim 1, further comprising
a heat dissipation part having heat dissipation fins and installed outside the charging space, and
a heat pipe connecting the heat dissipation part and the thermoelectric cooling part and arranged to transfer heat of the thermoelectric cooling part to the heat dissipation part.
